# EUROPEAN PATENT SPECIFICATION

(11) **EP 4 632 397 B1**
(45) Date of publication and mention of the grant of the patent: **05.08.2026**
(21) Application number: 25167061.8
(22) Date of filing: 28.03.2025
(51) Int. Cl.: G01R 31/28, G01R 31/30

(54) **STACKED PARAMETRIC MEASUREMENT UNIT TEST CIRCUIT**
PRÜFSCHALTUNG FÜR GESTAPELTE PARAMETRISCHE MESSEINHEIT
CIRCUIT DE TEST D'UNITÉ DE MESURE PARAMÉTRIQUE EMPILÉE

(30) Priority: 29.03.2024 US 202463571994 P; 11.03.2025 US 202519076762
(43) Date of publication of application: 15.10.2025
(73) Proprietor: Elevate Semiconductor, Inc., San Diego, California 92124 (US)
(72) Inventor: D'SOUZA, Sandeep Louis, San Diego, 92124 (US); CURRIN, Jeffrey Dial, San Diego, 92124 (US); LEIGH, Simon, San Diego, 92124 (US); SULLIVAN, Patrick, San Diego, 92124 (US)
(74) Representative: Barker Brettell LLP

(56) References cited:
- EP-B1- 0 136 205
- US-A1- 2006 132 163
- US-B1- 7 598 726

## Description

### Reference to Related Applications

The present application claims priority to U.S. Patent Application No. 19/076,762, filed March 11, 2025 and titled "STACKED PARAMETRIC MEASUREMENT UNIT TEST CIRCUIT," which claims priority to and the benefit of U.S. Patent Provisional Application No. 63/571,994, filed March 29, 2024 and titled "STACKED PARAMETRIC MEASUREMENT UNIT TEST CIRCUIT",

### Background

Electric vehicles (EVs) of all types (including hybrids) are becoming more prevalent as consumers increasingly adopt sustainable-energy-based technology. Relatedly, the amount of solar panel and stationary battery energy storage system (BESS) installations is increasing as homeowners and businesses increase their use of renewable solar energy. The above-referenced trends in EVs and BESSs are accelerated by worldwide government mandates.

A key component of EVs and BESSs is the battery pack. A battery pack typically includes a matrix of interconnected lithium-ion cells. Certain battery packs may include multiple battery modules - with each battery module including multiple lithium-ion cells stacked in series. The battery modules may be connected to each other via electrical busbars, for example. Modem battery packs in EVs and BESSs can be quite large. For instance, an example battery pack may include four battery modules - each including a matrix of series and/or parallel connected cells. For instance, an example battery module may include 6 to 30 cells in series, and 50 to 80 cells in parallel, giving a total between 300 and 2400 cells. The document US 7 598 726 B1 discloses a test circuit comprising first and second parametric measurement units. Each parametric measurement unit employs combined input and output terminals.

### Brief Description of the Drawings

The present disclosure, in accordance with one or more various examples, is described in detail with reference to the following figures. The figures are provided for purposes of illustration only and merely depict examples.
FIG. 1 illustrates an example test circuit, in accordance with various examples of the presently disclosed technology.
FIG. 2 illustrates another example test circuit, in accordance with various examples of the presently disclosed technology.
FIG. 3 illustrates another example test circuit, in accordance with various examples of the presently disclosed technology.
FIG. 4 illustrates a zoomed in view of an example parametric measurement unit (PMU) from the test circuit of FIG. 3, in accordance with various examples of the presently disclosed technology.
FIG. 5 illustrates a zoomed in view of an example isolated power supply from the test circuit of FIG. 3, in accordance with various examples of the presently disclosed technology.
FIG. 6 illustrates a zoomed in view of an example common-mode voltage source from the test circuit of FIG. 3, in accordance with various examples of the presently disclosed technology.
FIG. 7 illustrates a zoomed in view of an example configuration switch from the test circuit of FIG. 3, in accordance with various examples of the presently disclosed technology.
FIG. 8 illustrates another example test circuit, in accordance with various examples of the presently disclosed technology.

The figures are not exhaustive and do not limit the present disclosure to the precise form disclosed.

### Detailed Description

While battery-based EVs and BESSs can reduce dependence on fossil fuels, use of lithium-ion cells and other cell technologies introduces new safety, long-term reliability, and efficiency challenges. Such challenges can be addressed by specially designed battery management systems (BMSs).

An example BMS may include a BMS controller and a series of BMS integrated circuits (BMS ICs). The BMS ICs - typically one per battery module - can measure various parameters (e.g., voltage, current, temperature, etc.) at several locations of a battery pack. These measured parameters can be provided to algorithms running on the BMS controller such as a battery fuel gauge algorithm and an optimal charging algorithm. Leveraging these algorithms, the BMS controller can optimize (or otherwise improve) battery pack system-level metrics such as state-of-charge (SOC) and state-of-health (SOH). The BMS controller can also perform electrical and thermal cell balancing to improve efficiency, reliability, and safety for the battery pack.

Many BMSs are designed to meet stringent electrical specifications to improve/optimize performance and reliability. For example, a BMS' analog-front-end (AFE) and analog-to-digital converters (ADCs) which digitize cell and busbar voltages are often designed to have microVolt (uV) accuracy/precision. This is in part because a typical cell's discharge curve is relatively flat, which means that cell voltage should be measured with fine granularity to predict cell SOC. As another example, a BMS' voltage-sensing circuits are often designed to draw a very low current - typically in the microAmpere (uA) range - in order to reduce the amount the BMS discharges battery pack cells (here discharge by the BMS would be undesirable as charge resources are used to power EV and BESS systems). BMS charge-balancing circuitry is also often designed to meet stringent terminal input-impedance specifications.

While BMSs can play a critical role in improving safety, long-term reliability, and efficiency for EVs and BESSs, a BMS is often only as reliable as it can be tested. Accordingly, circuits used to test BMSs (BMS test circuits) may also play a critical role in improving safety, long-term reliability, and efficiency for battery-based products, including EVs and BESSs.

However, designing BMS test circuits can be a serious challenge. This is in part due to: (a) the stringent electrical specifications that BMSs are designed to; and (b) the increasing size of battery packs (e.g., sometimes as many as a stack of 6 to 30 series interconnection of cells).

For example, BMS test circuits (often implemented using ICs) generally should be as accurate/precise as the BMS devices-under-test (DUTs). Accordingly, BMS test circuits are often designed to measure and supply voltage with uV granularity (e.g., with steps of approximately 30 to 300 uV granularity). Likewise, BMS test circuits are often designed to measure and supply current as low as approximately 300nA to 1uA with a high level of precision. Compounding the challenges above, due to the increasing size of battery packs, the above-referenced testing is often performed at high voltages to emulate cells at the top/high end of a series connected stack. In general, voltage sources that supply high voltages at high precision/high granularity are expensive and have large form factors. This can be a problem where chip space is already at a premium on BMS test circuits due to the increasingly large number of cells included in modern battery modules. For example, BMS test circuits are often designed to emulate a battery module. If for example the battery module includes 16 cells, a conventional BMS test circuit would generally require 16 channels just to emulate the voltage supplied by those 16 cells. Thus, the high channel density (i.e., density of channels) on many BMS test circuits can limit the size available for circuit components such as large form factor voltage sources.

The present invention provides a test circuit according to claim 1, a system according to claim 6 and a test method according to claim 11.

Embodiments of the presently disclosed technology may be implemented to provide new, compact circuit architectures designed to measure and supply high voltages with high precision/high granularity. Such designs are well-suited for BMS test circuits, as well as other applications that demand compact circuits for measuring and supplying high voltages with high precision/high granularity. Such circuit architectures may also supply and measure low currents with high precision - which is another feature well-suited for BMS test circuits and many other applications.

For example, a test circuit of the presently disclosed technology may include a "stacked precision parametric measurement unit (PMU)" including a precision PMU connected in series with a common-mode (CM) voltage source / power supply. The common-mode voltage source may be configured to supply a relatively large range of voltages (e.g., -100 V to 100 V), such as might be suitable for testing BMS ICs. By contrast, the precision PMU may include a voltage source that supplies/measures voltage over a relatively smaller range (e.g., -2 V to 6 V relative to the common-mode voltage source) at high precision and granularity (e.g., in uV steps, such as 30 to 300uV voltage steps). Because the precision PMU can supply/measure more granular voltage steps, the common-mode voltage source can be a lower precision voltage source. Accordingly, the common-mode voltage source may have a smaller form factor (and smaller expense) than an alternative voltage source that provides higher precision across a comparable voltage range. Relatedly (and as described in greater detail below), connecting a return line for the precision PMU above the terminal at the output of the common-mode voltage source can help reject/reduce noise produced by the high-voltage common-mode voltage source by canceling the noise through use of a floating ground and differential signal. Accordingly, higher noise yet more power efficient voltage sources (e.g., SMPS voltage sources) can be used for the common-mode voltage source.

In some embodiments, the test circuit may include a demultiplexer to connect outputs from the "stacked" PMU to cell-voltage (CV) and cell-balance (CB) terminals of a device-under-test (DUT). In this way, the test circuit can support multiple DUT CV and CB terminals. The demultiplexer may be discrete to support more flexibility or integrated with the "stacked" PMU (e.g., IC) to reduce area on a device-interface-board (DIB). An example demultiplexer may include transistor-based switches and circuits and/or can include micro-electromechanical systems (MEMS) switching-matrices.

Digital-to-analog converters (DACs) can also be used with the "stacked" PMU to drive the DUT terminals, e.g., in a force-voltage (FV) mode or a force-current (FI) mode. Various types of DACs are contemplated, including DACs with various resolutions (e.g., 16-bit DACs, etc.) and architectures (e.g., delta-sigma or Nyquist). The DAC(s) can be integrated within the "stacked" PMU IC or provided externally as part of a separate IC and/or on a circuit board. Independent of drive mode, a high dynamic-range analog-front-end of the "stacked" PMU can measure a response of the DUT terminal voltages (e.g., between +25V and -25V) to uV precision in a measure voltage (MV) mode. Likewise, the high dynamic-range analog-front-end of the "stacked" PMU can measure DUT currents (e.g., between 2uA and 1A) in a measure current (MI) mode.

As alluded to above, the "stacked" PMU can operate in any one or a combination of a force-voltage (FV) mode, a force-current (FI) mode, a measure-voltage (MV) mode, and a measure-current (MI) mode. In the FV mode, channels of the "stacked" PMU may support output a relatively large range of voltages (e.g., ranging from -100V to 100V), with a fine precision (e.g., 100uV plus or minus). In the FI mode, the "stacked" PMU may be configured to source current across a relatively large range (e.g., from 1uA to 1A or more). These capabilities can allow the "stacked" PMU to test a BMS IC under several battery-pack conditions and EV / BESS operational modes. In some implementations, by adjusting an "offset" of voltages and/or currents applied by the "stacked" PMU, the "stacked" PMU may be floated across a large +/-100V compliance range.

In certain embodiments, the "stacked" PMU may include one or more integrated clamp circuits that limit voltages and/or currents applied to the DUT, thereby protecting the DUT from overstress conditions outside its designed operating regime. Additionally, channels of the precision PMU may be equipped with alarm features to detect temperature, voltage, current, and force/sense Kelvin faults. Monitor analog outputs may be included to connect to external components. Window comparators may also be used for rapid comparison of measured parameters to predefined thresholds.

In some embodiments, the "stacked" PMU may be configurable to use both internally generated precision-signals (e.g., via one or more DACs) or external analog or digital test signals. In addition to setting static values, a pattern may be programmed into the embedded memory and outputted from the "stacked" PMU. The "stacked" PMU may include an embedded Serial Peripheral Interface (SPI) peripheral that enables the "stacked" PMU to be controlled by embedded SPI controllers in a variety of field programmable gate array (FPGA), microprocessor or other test equipment systems and/or circuits.

Example embodiments are described in greater detail below. It should be understood that the various features, aspects and functionality described in one or more of the individual embodiments are not limited in their applicability to the particular embodiment with which they are described. Instead, they can be applied, alone or in various combinations, to one or more other embodiments, whether or not such embodiments are described and whether or not such features are presented as being a part of a described embodiment. Thus, the breadth and scope of the present application should not be limited by any of the above-described exemplary embodiments Said scope is defined by the appended claims.

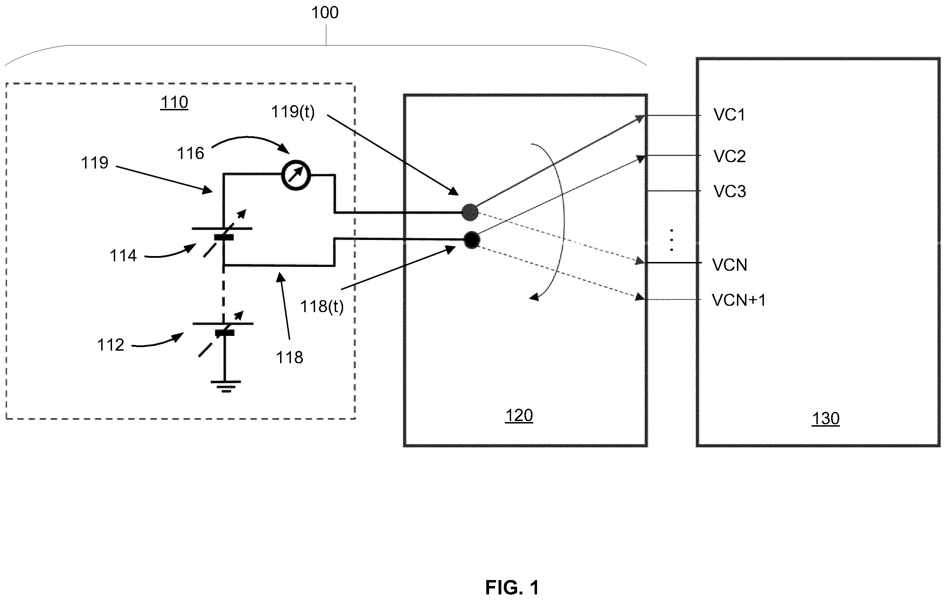

FIG. 1 illustrates an example test circuit 100, in accordance with various examples of the presently disclosed technology.

As depicted, test circuit 100 can be used to test a DUT 130. In various examples, DUT 130 may include a BMS IC, although this need not be the case.

In the specific example of FIG. 1, test circuit 100 includes a stacked PMU 110 and a demultiplexer 120.

As depicted, the example stacked PMU 110 includes a common-mode voltage source 112 and a precision voltage source 114 electrically connected to each other in series (e.g., "stacked"). Common-mode voltage source 112 may be connected between ground (e.g., global or true ground) and a terminal on the "low side" (i.e., lower voltage side) of precision voltage source 114 that can be used to apply a differential voltage to terminals of DUT 130 (e.g., VC1, VC2).

In certain embodiments, stacked PMU 110 may also include a current meter 116 electrically connected in series with precision voltage source 114. As depicted, in some of these embodiments current meter 116 may be electrically connected to a terminal of precision voltage source 114 on the "high side" (i.e., the higher voltage side) of precision voltage source 114. The combination of precision voltage source 114 and current meter 116 may be referred to as a precision PMU. However, it should be understood that this is just one example implementation / example mode of operation for a precision PMU - sometimes referred to as a force-voltage-measure-current (FVMI) mode of operation. Other example implementations / example modes of operation may include: (a) force-current-measure-voltage (FIMV) which may be implemented using a current source connected in parallel with a voltmeter; (b) force-current-measure-current (FIMI); and (c) force-voltage-measure-voltage (FVMV).

Stacked PMU 110 may also include a supply / high path 119 and a return / low path 118. Supply / high path 119 connects the high side terminal of precision voltage source 114 to a supply / high terminal 119(t). As described in greater detail below, demultiplexer 120 can connect supply / high terminal 119(t) to a high side (i.e., higher voltage side) of a differential voltage being applied to terminals of DUT 130 (e.g., the positive voltage of the differential signal is applied to cell voltage terminal VC1). Return / low path 118 connects the low side terminal of precision voltage source 114 to a return / low terminal 118(t). As described in greater detail below, demultiplexer 120 can connect return / low terminal 118(t) to a low side (i.e., lower voltage side) terminal of a differential (e.g., negative) voltage being applied to terminals of DUT 130 (e.g., to cell voltage terminal VC2).

As depicted, return / low path 118 may connect to the low side terminal of precision voltage source 114 above the output terminal of common-mode voltage source 112. By this design, return / low path 118 can provide a differential signal and floating ground that enables rejection of noise produced by common-mode voltage source 112. Accordingly, embodiments of the present disclosure enable test circuits to use noisier voltage sources (e.g., switching-mode-power-supply (SMPS) voltage sources) for common-mode voltage source 112, thus reducing power consumption and implementation cost as well as size (and thus increasing the possible density of the test circuit) for stacked PMU 110. However, it should be understood that various types of voltage sources may be used for common-mode voltage source 112, including other types of SMPS voltage sources and non-SMPS voltage sources. For instance, in some implementations common-mode voltage source 112 may comprise an SMPS voltage source whose output is connected to a linear regulator such as a low-dropout regulator (LDO). In other implementations, common-mode voltage source 112 may comprise the LDO alone, etc.

Referring again to common-mode voltage source 112, common-mode voltage source 112 may be configured to supply a relatively large range of voltages suitable for testing BMS ICs (e.g., -100 V to 100 V). Because precision voltage source 114 can supply/measure precision voltage steps (e.g., 30 to 300uV voltage steps), common-mode voltage source 112 may be a lower precision voltage source. Accordingly, common-mode voltage source 112 may have a smaller form factor (and smaller expense) than an alternative voltage source that must provide higher precision across the same/similar voltage range. Relatedly (and as described above), because return / low path 118 is connected to the low side terminal of precision voltage source 114 above the output terminal of common-mode voltage source 112, return / low path 118 provides a differential signal and floating ground that can aid in rejecting noise produced by common-mode voltage source 112. Accordingly, higher noise voltage sources (e.g., SMPS voltage sources) can be used for common-mode voltage source 112 at lower power consumption and less expense.

Referring now to precision voltage source 114, precision voltage source 114 may be configured to supply and measure a relatively lower range of voltages (as compared to common-mode voltage source 112 for example) at a relatively higher precision. For example, precision voltage source 114 may supply/measure a range of -2 V to 6 V (relative to common-mode voltage source 112) in granular steps, such as approximately 30 to 300 uV steps, or whatever steps size may be required for purposes of testing the DUT.

As described above, the example stacked PMU 110 can operate in any one or a combination of force-voltage (FV) mode, a force-current (FI) mode, a measure-voltage (MV) mode, and a measure-current (MI) mode. In the FV mode, channels of stacked PMU 110 may support output voltages ranging from, for example, -100V to 100V, with a high level of precision, such as 100uV. In the FI mode, stacked PMU 110 may be configured to source current ranging from approximately 1uA to 1A, by way of example. These capabilities can advantageously allow stacked PMU 110 to test DUT 130 under multiple battery-pack conditions and EV / BESS operational modes. In some implementations, by adjusting an "offset" of voltages and currents applied by stacked PMU 110, they may be floated across a large (e.g., +/-100V) compliance range

In certain embodiments, stacked PMU 110 may include one or more integrated or external clamp circuits (not depicted) that limit and/or control voltage and current conditions applied to DUT 130, thereby protecting DUT 130 from overstress conditions outside its designed operating regime and preventing possible damage or failure. Additionally, channels of stacked PMU 110 may be equipped with alarm features that can detect temperature, voltage, current and force/sense Kelvin faults. Monitor analog outputs may be included to connect to external components such as analog-to-digital converters (ADCs) or associated analog-front-end amplifiers or filters. Window comparators may also be used for rapid comparison of measured parameters to predefined thresholds. In certain embodiments, the window comparators may be implemented/embedded in stacked PMU 110. An output of a window comparator may be a binary high/low signal which may be connected to an external field programmable gate array (FPGA), microprocessor or microcontroller in a larger testing system

In some embodiments, stacked PMU 110 may be configurable to use both internally generated precision-signals (e.g., via one or more DACs that can have suitable resolution(s), for example 20 bits) or external or internal analog test signals. In addition to setting (e.g., static) values, a pattern may be programmed into the embedded memory of and outputted from stacked PMU 110. In certain embodiments, stacked PMU 110 may include an embedded Serial Peripheral Interface (SPI) peripheral (not depicted) that enables stacked PMU 110 to be controlled by embedded SPI controllers in a variety of manners, e.g., field programmable gate array (FPGA), microprocessor or other test equipment systems and/or circuits.

Referring again to demultiplexer 120, demultiplexer 120 can selectively connect: (1) supply / high terminal 119(t) to a high side terminal (i.e., higher voltage side) of a source providing a positive differential voltage signal being applied to DUT 130; and (2) return / low terminal 118(t) to a low side terminal (i.e., lower voltage side) of a source providing a negative differential voltage signal being applied to DUT 130. For example, in a first mode/setting of demultiplexer 120, demultiplexer 120 can connect supply / high terminal 119(t) to cell voltage terminal VC1, and return / low terminal 118(t) to cell voltage terminal VC2 of DUT 130. Accordingly, stacked PMU 110 can test/measure the voltage differential between cell voltage terminal VC1 and cell voltage terminal VC2. In a second mode/setting of demultiplexer 120, demultiplexer 120 can connect supply / high terminal 119(t) to cell voltage terminal VCN-1, and return / low terminal 118(t) to cell voltage terminal VCN of DUT 130.

In some embodiments, demultiplexer 120 may include a MEMS switching matrix, however in other implementations other demultiplexers/devices may be used, and demultiplexer may be external to stacked PMU 110 (e.g., another IC or component) or integrated therein.

As alluded to above, DUT 130 may include various types of devices, including a BMS IC. While in the specific example of FIG. 1 only cell voltage terminals are depicted (i.e., cell voltage terminals VC1-VCN), in various implementations DUT 130 may include other terminals to be tested, such as cell-balance terminals or other types of terminals.

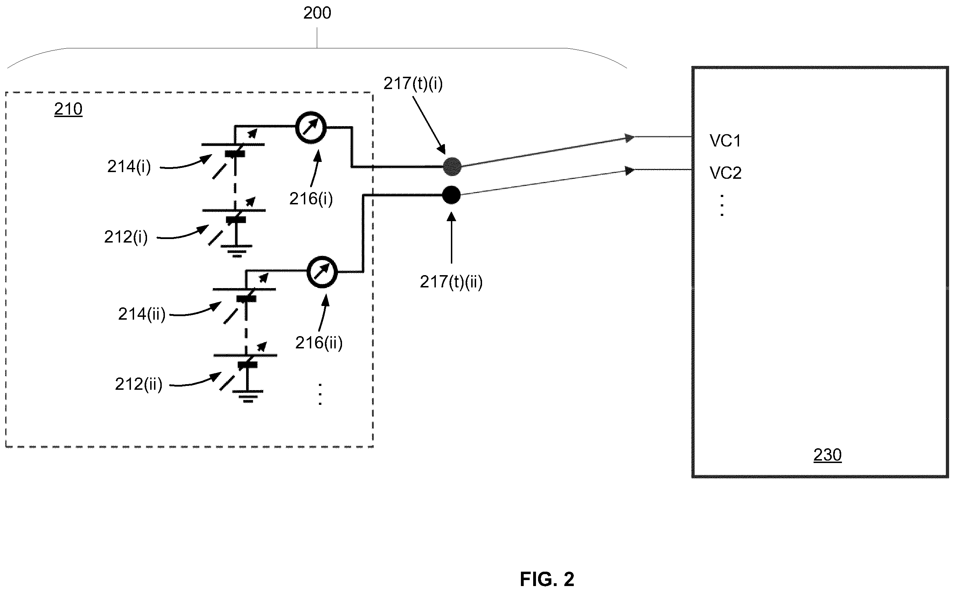

FIG. 2 illustrates an example test circuit 200, in accordance with various examples of the presently disclosed technology.

Unlike test circuit 100, example test circuit 200 may exclude a demultiplexer. Instead, test circuit 200 may include a stacked PMU 210 having a "common-mode voltage source-precision PMU stack" for each channel of DUT 230.

For example, a first common-mode voltage source-precision PMU stack may be connected to cell voltage terminal VC1 of DUT 230 via terminal 217(t)(i) of test circuit 200. The first common-mode voltage source-precision PMU stack may include : (a) common-mode voltage source 212(i); (b) precision voltage source 214(i) connected in series with common-mode voltage source 212(i); and/or (c) current meter 216(i).

Likewise, a second common-mode voltage source-precision PMU stack may be connected to cell voltage terminal VC2 of DUT 230 via terminal 217(t)(ii) of test circuit 200. The second common-mode voltage source-precision PMU stack may include: (a) common-mode voltage source 212(ii); (b) precision voltage source 214(ii) connected in series with common-mode voltage source 212(ii); and/or (c) current meter 216(ii).

While not depicted, stacked PMU 210 may include additional common-mode voltage source-precision PMU stack, e.g., for each channel of DUT 230.

Precision voltage source 214(i) and precision voltage source 214(ii) may be the same/similar as precision voltage source 114 of test circuit 100. Likewise, current meter 216(i) and current meter 216(ii) may be the same/similar as current meter 116 of test circuit 100. Accordingly, the combination of precision voltage source 214(i) and current meter 216(i) may be referred to as a first precision PMU. Likewise, the combination of precision voltage source 214(ii) and current meter 216(ii) may be referred to as a second precision PMU.

Common-mode voltage source 212(i) and common-mode voltage source 212(ii) may also be similar to common-mode voltage source 112 of test circuit 100. However, because common-mode voltage source 212(i) and common-mode voltage source 212(ii) are channel specific, they may not need to supply as large a range of voltages as common-mode voltage source 112.

A potential advantage of test circuit 200 over test circuit 100 is that more channels (potentially all channels) of DUT 230 can be test simultaneously. By contrast, test circuit 100 may only test a single voltage differential at a time. Accordingly, test circuit 200 may facilitate faster and larger-scale testing than test circuit 100.

However, test circuit 100 may provide certain advantages over test circuit 200, including, for example, smaller/more compact form factor and fewer electrical components. Relatedly, because stacked PMU 110 includes a return / low line 118 (e.g., floating ground) connected above common-mode voltage source 112, such a return line can help reject/reduce noise produced by common-mode voltage source 112 from reaching precision DUT 130. By contrast, in embodiments where test circuit 200 lacks such return lines to its constituent precision voltage sources, stacked PMU 210 may need to address noise through other mechanisms. In other embodiments, stacked PMU 210 may employ one or more floating grounds and differential voltages/signals or a combination of single-ended and differential voltages/signals.

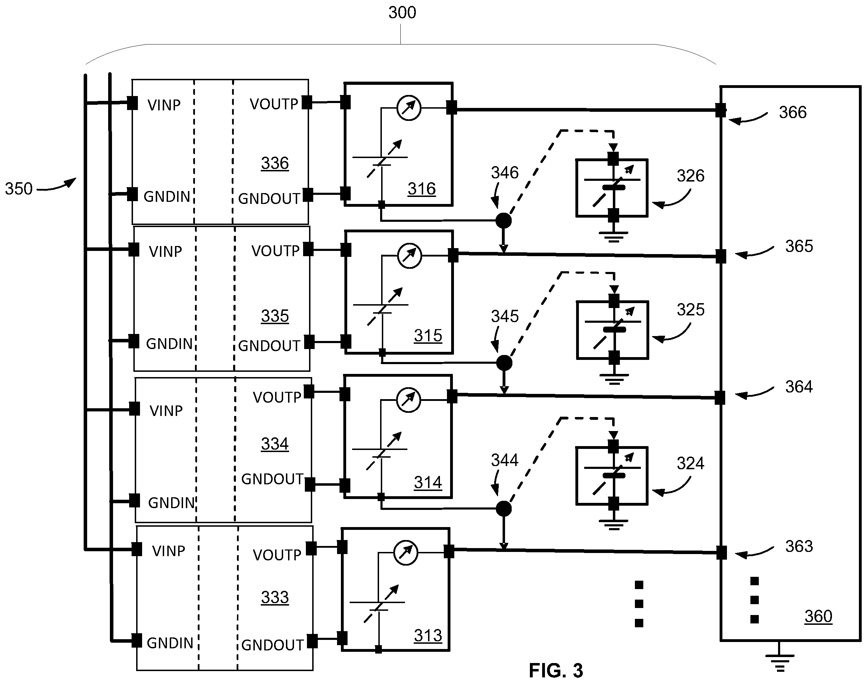

FIG. 3 illustrates another test circuit 300 in accordance with various examples of the presently disclosed technology.

As depicted, test circuit 300 includes a series-connected stack of floating-ground PMUs (e.g., PMUs 316, 315, 314, 313, and in some implementations additional PMUs connected in series below PMU 313) connected to a DUT 360 and configured to test if DUT 360's cell-voltage (CV) and cell-balance (CB) terminal characteristics meet applicable specifications. This floating-ground-based topology can meet common-mode and uV/uA precision requirements, for example as described herein. Each PMU may have an isolated power supply (e.g., isolated power supply 336 for PMU 316, isolated power supply 335 for PMU 315, isolated power supply 334 for PMU 314, and isolated power supply 333 for PMU 313) for, e.g., galvanic isolation of the PMU circuitry from a system input power supply 350. In this configuration, DACs (e.g., 20-bit or other resolution DACs) integrated in each PMU can drive DUT 360's CV and CB terminals (e.g., terminals 366, 365, 364 and 363) in force-voltage (FV) or force-current (FI) mode or a combination there and validate the DUT battery-cell-measurement, input-current and CB switch-transistor on-resistance capabilities from the DUT measure-current (MI) and measure-voltage (MV) responses. Each PMU FV or FI stimulus can be independently programmed using test equipment software, thereby enabling emulation of any battery cell condition. Certain embodiments can extend the testable DUT voltage range up to its maximum rating by connecting each PMU in series with a common-mode, efficient switching-mode-power-supply (SMPS) (e.g., common-mode voltage source 326 for PMU 316, common-mode voltage source 325 for PMU 315, common-mode voltage source 324 for PMU 314, etc.). Test circuit 300 can be reconfigurable between a first high-precision topology and a second extended-voltage-range topology using switching matrices (e.g., a switching matrix including switch 346 selectively connecting PMU 316 in series with PMU 315, switch 345 selectively connecting PMU 315 in series with PMU 314, switch 344 selectively connecting PMU 314 in series with PMU 313, etc.). These switching matrices / switches may be discrete to support more flexibility, or integrated with or within a respective PMU, e.g., as co-packaged Micro-Electromechanical Systems (MEMS) switches. At the circuit level, one or more integrated clamp circuits in a respective PMU can limit the voltage and current across DUT 360. In some cases, the clamps may be external to the respective PMU. Additionally, each PMU may have alarm features for detecting temperature, voltage, current and force/sense Kelvin faults, etc.

Referring again to FIG. 3, as depicted each PMU may be powered by an isolated power supply. The isolation of the power supply can enable the PMUs to be electrically connected in series, while maintaining their supply voltage lower relative to that of the total series voltage.

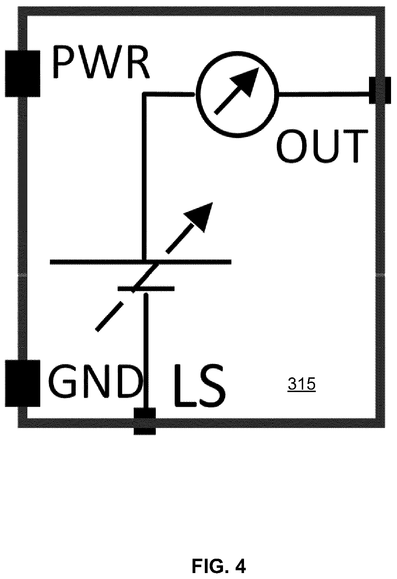

FIG. 4 illustrates a zoomed in view of PMU 315 from test circuit 300 of FIG. 3, in accordance with various examples of the presently disclosed technology.

As shown in FIG. 4, GND may refer to the ground terminal of PMU 315's power supply. PWR may refer to the positive terminal of PMU 315's power supply. OUT may refer to an output terminal of PMU 315. LS may refer to a low-sense terminal of PMU 315.

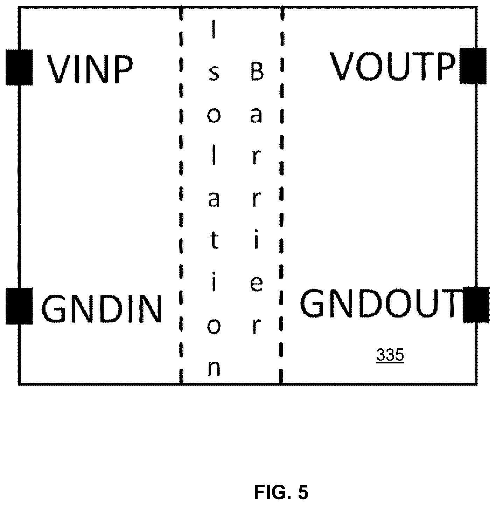

FIG. 5 illustrates a zoomed in view of isolated power supply 335 from test circuit 300 of FIG. 3, in accordance with various examples of the presently disclosed technology.

As shown in FIG. 5, VINP may refer to a positive terminal of input power supply for isolated power supply 335. GNDIN may refer to a ground terminal of input power supply for isolated power supply 335. VOUTP may refer to a positive terminal of output power supply for isolated power supply 335. GNDOUT may refer to a ground terminal of output power supply for isolated power supply 335. Isolation Barrier may refer to a transformer or other electrical isolation incorporated into isolated power supply 335.

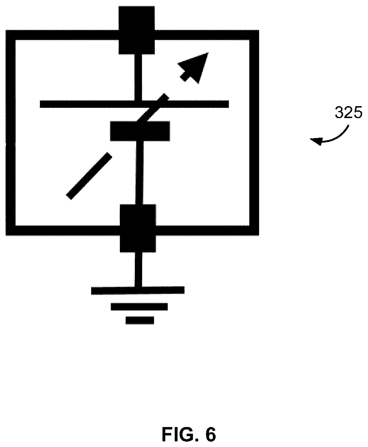

FIG. 6 illustrates a zoomed in view of common-mode voltage source 325 from test circuit 300 of FIG. 3, in accordance with various examples of the presently disclosed technology. As an example, common-mode voltage source 325 may supply voltages between -100 V and 100 V.

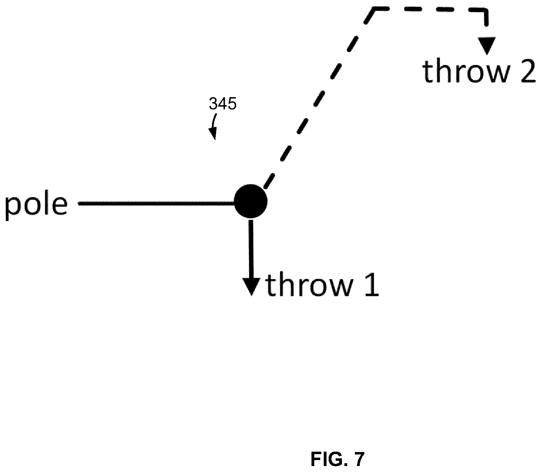

FIG. 7 illustrates a zoomed in view of switch 345 from test circuit 300 of FIG. 3, in accordance with various examples of the presently disclosed technology.

As shown in FIG. 7, switch 345 can configure test circuit 300 between: (a) a normal voltage, high precision mode in which the pole of switch 345 is connected to throw 1 of switch 345, thereby connecting PMU 315's low-sense terminal to the output terminal of the PMU 314; and (b) an extended voltage, lower precision mode in which the pole of switch 345 is connected to throw 2 of switch 345, thereby connecting PMU 315's low-sense terminal to common-mode power supply 325.

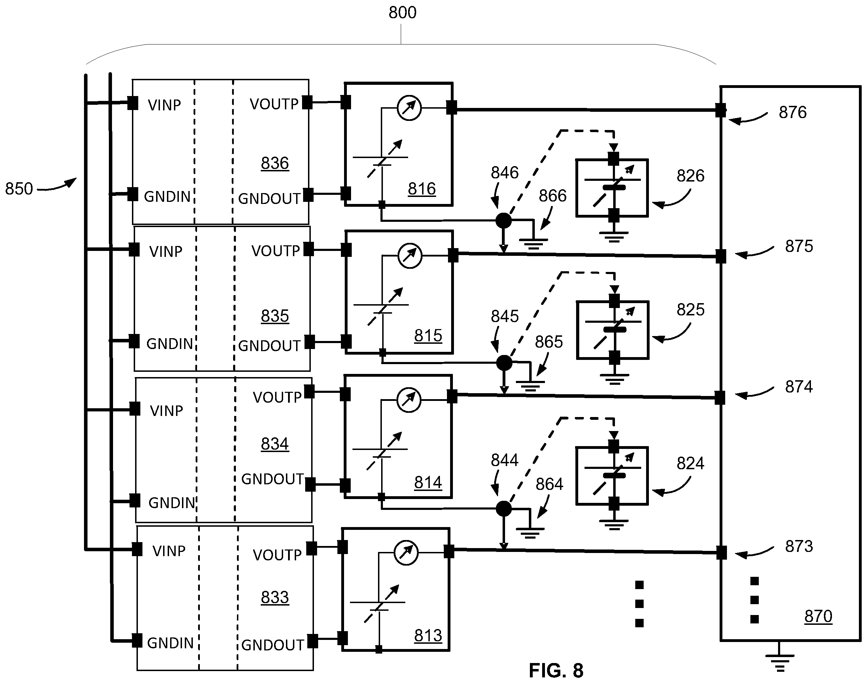

FIG. 8 illustrates another test circuit 800, in accordance with various examples of the presently disclosed technology.

As depicted, test circuit 800 can includes a series-connected stack of floating-ground PMUs (e.g., PMUs 816, 815, 814, 813 and in some implementations additional PMU's connected in series below PMU 813), which are connected to DUT 870. The PMUs are configured to test whether DUT 870's cell-voltage (CV) and cell-balance (CB) terminal characteristics meet applicable specifications. Each PMU may have an isolated power supply (e.g., isolated power supply 836 for PMU 816, isolated power supply 835 for PMU 815, isolated power supply 834 for PMU 814, isolated power supply 833 for PMU 813) for, e.g., galvanic isolation of the PMU circuitry from a system input power supply 850. Each PMU may be connected in series with a common-mode voltage source (e.g., common-mode voltage source 826 for PMU 816,common-mode voltage source 825 for PMU 815, common-mode voltage source 824 for PMU 814, etc.). While in the specific embodiments of FIG. 8 each PMU is connected to a dedicated/separate common voltage source, in one or more embodiments, PMUs may be connected to the same common voltage source. However, connecting each PMU to a dedicated/separate common-mode voltage source can facilitate independent control advantages where, for example, the common-mode voltage source connected to a first PMU needs to provide a different voltage output than a common-mode voltage source connected to a second PMU.

As shown in FIG. 8, the two-way switches in FIG. 3 can be replaced by three-way switches (i.e., switches 846, 845, 844, and in some implementations, additional switches connected below switch 844 in FIG. 8).

For example, in its first configuration, switch 846 can connect a low sense terminal PMU 816 to an output terminal of PMU 815. Relatedly, in its first configuration, switch 845 can connect a low sense terminal PMU 815 to an output terminal of PMU 814. Similarly, in its first configuration, switch 844 can connect a low sense terminal PMU 814 to an output terminal of PMU 813. Accordingly, in the first configuration of the switches, the PMUs of test circuit 800 can be connected in series to emulate a battery stack to be managed by DUT 870 (which as described above, may be a battery management system (BMS)). Thus, in this first configuration of the switches, test circuit 800 can test an ability of DUT 870 (e.g., a BMS) to measure individual terminal voltages of the battery stack being emulated by test circuit 800.

In its second configuration, switch 846 can connect the low sense terminal PMU 816 to ground 866. Relatedly, in its second configuration, switch 845 can connect the low sense terminal PMU 815 to ground 865. Similarly, in its second configuration, switch 844 can connect the low sense terminal PMU 814 to ground 864. Thus, in the second configuration of the switches, test circuit 800 may be configured to test low voltage characteristics of DUT 870 (e.g., characteristics of DUT 870 that are tested at relatively lower voltages, such as between 0-5 Volts). Non-limiting examples of low voltage characteristics may include: (a) a differential voltage between successive terminals of DUT 870; (b) battery cell ADC resolution for DUT 870; and (c) other characteristics of DUT 870 that are tested at relatively lower voltages (e.g., 0-5 Volts).

In its third configuration, switch 846 can connect the low sense terminal PMU 816 to common-mode voltage source 826. Relatedly, in its third configuration, switch 845 can connect the low sense terminal PMU 815 to common-mode voltage source 825. Similarly, in its third configuration, switch 844 can connect the low sense terminal PMU 814 to common-mode voltage source 824. Thus, in the third configuration of the switches, test circuit 800 may be configured test high voltage characteristics of DUT 870 (e.g., characteristics of DUT 870 that are tested at relatively higher voltages, such as between 60-100 Volts). Non-limiting examples of high voltage characteristics may include: (a) absolute maximum rated voltage of the cell voltage terminals of DUT 870; (b) leakage current from a cell voltage terminal of DUT 870 when a maximum rated voltage is applied; and (c) other characteristics of DUT 870 that are tested at relatively higher voltages (e.g., 60-100 Volts).

In one or more embodiments, the PMU(s) may connect directly to input power supply 850. This can allow for embodiments that do not include galvanic isolation modules, which may allow for lower costs and higher efficiency with less power loss.

Terms and phrases used in this document, and variations thereof, unless otherwise expressly stated, should be construed as open ended as opposed to limiting. As examples of the foregoing, the term "including" should be read as meaning "including, without limitation" or the like. The term "example" is used to provide exemplary instances of the item in discussion, not an exhaustive or limiting list thereof. The terms "a" or "an" should be read as meaning "at least one," "one or more" or the like; and adjectives such as "conventional," "traditional," "normal," "standard," "known." Terms of similar meaning should not be construed as limiting the item described to a given time period or to an item available as of a given time. Instead, they should be read to encompass conventional, traditional, normal, or standard technologies that may be available or known now or at any time in the future. Where this document refers to technologies that would be apparent or known to one of ordinary skill in the art, such technologies encompass those apparent or known to the skilled artisan now or at any time in the future.

The presence of broadening words and phrases such as "one or more," "at least," "but not limited to" or other like phrases in some instances shall not be read to mean that the narrower case is intended or required in instances where such broadening phrases may be absent. The use of the term "component" does not imply that the aspects or functionality described or claimed as part of the component are all configured in a common package. Indeed, any or all of the various aspects of a component, whether control logic or other components, can be combined in a single package or separately maintained and can further be distributed in multiple groupings or packages or across multiple locations.

Additionally, the various embodiments set forth herein are described in terms of exemplary block diagrams, flow charts and other illustrations. As will become apparent to one of ordinary skill in the art after reading this document, the illustrated embodiments and their various alternatives can be implemented without confinement to the illustrated examples. For example, block diagrams and their accompanying description should not be construed as mandating a particular architecture or configuration. The scope of the present invention is defined by the claims.

## Claims

1. A test circuit (300; 800) comprising:
a first parametric measurement unit, PMU, (316; 816) comprising:
a first electrical source (336; 836),
an output terminal to connect the first electrical source to a first terminal of a device-under-test, DUT, (360; 860), and
a low-sense terminal;
a second PMU (315; 815) comprising:
a second electrical source (335; 835), and
an output terminal to connect the second electrical source to a second terminal of the DUT;
a common-mode voltage source (326; 826), wherein the common-mode voltage source is configured to provide a larger range of voltages at lower precision steps than the first and second electrical sources; and
a switch (346; 846) with configurations comprising:
a first configuration where the switch connects the low-sense terminal of the first PMU to the output terminal of the second PMU, and
a second configuration where the switch connects the low-sense terminal of the first PMU to the common-mode voltage source.

2. The test circuit of claim 1, wherein:
the DUT comprises a battery management system, BMS;
the configurations for the switch further comprise a third configuration where the switch connects the low-sense terminal of the first PMU to ground;
in the first configuration of the switch, the first PMU and the second PMU are connected in series to emulate a battery stack to be managed by the BMS;
in the second configuration of the switch, the first PMU is configured to test a high voltage characteristic of the BMS; and
in the third configuration of the switch, the first PMU is configured to test a low voltage characteristic of the BMS.

3. The test circuit of claim 2, wherein in the first configuration of the switch the test circuit is configured to test an ability of the BMS to measure individual terminal voltages of a battery stack.

4. The test circuit of claim 2 or claim 3, wherein the test circuit further comprises a number "M" PMUs (313-316; 813-816) and in the first configuration of the switch the test circuit is configured to emulate the battery stack comprising a number "M + 2" battery modules, wherein the number "M" comprises four or more.

5. The test circuit of claim 2, or claim 3 or claim 4, wherein the test circuit further comprises a number "N" PMUs (313-316; 813-816) and in the first configuration of the switch the test circuit is configured to emulate the battery stack comprising a number "N + 2" battery packs, wherein the number "N+2" comprises an integer multiple of four.

6. A system comprising:
the DUT (360; 860), and
the test circuit (300; 800) according to claim 1,
wherein the switch (346; 846) has configurations consisting of:
the first configuration where the switch connects the low-sense terminal of the first PMU to the output terminal of the second PMU, and
the second configuration where the switch connects the low-sense terminal of the first PMU to the common-mode voltage source.

7. The system of claim 6, wherein the test circuit further comprises:
a third PMU (314; 814) comprising:
a third electrical source (334; 834), and
an output terminal to connect the third electrical source to a third terminal of the DUT;
a second common-mode voltage source (325; 825), wherein the second common-mode voltage source is configured to provide a larger range of voltages at lower precision steps than the first, second, and third electrical sources; and
a second switch (345; 845);
wherein:
the second PMU further comprises a low-sense terminal, and
configurations for the second switch consist of:
a first configuration where the second switch connects the low-sense terminal of the second PMU to the output terminal of the third PMU, and
a second configuration where the second switch connects the low-sense terminal of the second PMU to the second common-mode voltage source.

8. The system of claim 6 or claim 7, wherein:
the first electrical source is a first isolated power supply electrically connected to supply a first voltage to the first PMU;
the second electrical source is a second isolated power supply electrically connected to supply a second voltage to the second PMU; and
the first and second voltages have higher precision than the common-mode voltage source.

9. The system of claim 8, wherein:
the first isolated power supply comprises a voltage input terminal, a voltage output terminal connected to the first PMU, and a first galvanic isolation barrier separating the voltage input terminal from the voltage output terminal;
the second isolated power supply comprises a voltage input terminal, a voltage output terminal connected to the second PMU, and a second galvanic isolation barrier separating the voltage input terminal of the second isolated power supply from the voltage output terminal of the second isolated power supply; and
the voltage input terminal of the first isolated power supply and the voltage input terminal of the second isolated power supply are connected to a common input power supply (350; 850).

10. The system of claim 6, or any of claims 7 to 9 wherein the first electrical source comprises at least one of:
a first precision voltage source to drive the first terminal of the DUT in a force-voltage, FV, mode; or
a first precision current source to drive the first terminal of the DUT in a force-current, FI, mode.

11. A method for using a test circuit (300; 800), the method comprising:
connecting an output terminal of a first parametric measurement unit, PMU, (300; 800) of the test circuit to a first terminal of a device-under-test, DUT, (360; 860);
connecting an output terminal of a second PMU (315; 815) of the test circuit to a second terminal of the DUT; and
configuring a switch (346; 846) of the test circuit into one of the following configurations:
a first configuration where the switch connects a low-sense terminal of the first PMU to the output terminal of the second PMU,
a second configuration where the switch connects the low-sense terminal of the first PMU to ground, and
a third configuration where the switch connects the low-sense terminal of the first PMU to a common-mode voltage source (326; 826) of the test circuit;
wherein the common-mode voltage source is configured to provide a larger range of voltages at lower precision steps than electrical sources of the first and second PMUs respectively.

12. The method of claim 11, wherein:
the DUT comprises a battery management system, BMS;
in the first configuration of the switch, the first PMU and the second PMU are connected in series to emulate a battery stack to be managed by the BMS;
in the second configuration of the switch, the first PMU is configured to test a low voltage characteristic of the BMS; and
in the third configuration of the switch, the first PMU is configured to test a high voltage characteristic of the BMS.

13. The method of claim 12, wherein in the first configuration of the switch the test circuit is configured to test an ability of the BMS to measure individual terminal voltages of a battery stack.

14. The method of claim 11, or claim 12 or claim 13, wherein the electrical source of the first PMU comprises one or more digital-to-analog converters, DACs, and an amplifier to drive terminals of the DUT in a force-voltage, FV, mode, a force-current, FI, mode, or a combination thereof.

15. The method of claim 11, or any of claims 11 to 14, wherein the test circuit further comprises:
a first isolated power supply (336; 836) electrically connected to supply a first voltage to the first PMU; and
a second isolated power supply (335; 835) electrically connected to supply a second voltage to the second PMU;
wherein the first and second voltages have higher precision than the common-mode voltage source.

## Patentansprüche

1. Prüfschaltung (300; 800), umfassend:
eine erste parametrische Messeinheit, PMU, (316; 816), umfassend:
eine erste Elektroquelle (336; 836),
einen Ausgangsanschluss, um die erste Elektroquelle mit einem ersten Anschluss eines Prüflings, DUT, (360; 860) zu verbinden, und
einen Low-Sense-Anschluss;
eine zweite PMU (315; 815), umfassend:
eine zweite Elektroquelle (335; 835) und
einen Ausgangsanschluss, um die zweite Elektroquelle mit einem zweiten Anschluss des DUT zu verbinden;
eine Gleichtaktspannungsquelle (326; 826), wobei die Gleichtaktspannungsquelle dazu konfiguriert ist, einen größeren Spannungsbereich bei niedrigeren Präzisionsschritten als die erste und die zweite Elektroquelle bereitzustellen; und
einen Schalter (346; 846) mit Konfigurationen, umfassend:
eine erste Konfiguration, bei welcher der Schalter den Low-Sense-Anschluss der ersten PMU mit dem Ausgangsanschluss der zweiten PMU verbindet, und
eine zweite Konfiguration, bei welcher der Schalter den Low-Sense-Anschluss der ersten PMU mit der Gleichtaktspannungsquelle verbindet.

2. Prüfschaltung nach Anspruch 1, wobei:
der DUT ein Batteriemanagementsystem, BMS, umfasst;
die Konfigurationen für den Schalter ferner eine dritte Konfiguration umfassen, bei welcher der Schalter den Low-Sense-Anschluss der ersten PMU mit Masse verbindet;
in der ersten Konfiguration des Schalters die erste PMU und die zweite PMU in Reihe geschaltet sind, um einen von dem BMS zu verwaltenden Batteriestapel zu emulieren;
in der zweiten Ausgestaltung des Schalters die erste PMU dazu konfiguriert ist, eine Hochspannungskennlinie des BMS zu prüfen; und
in der dritten Ausgestaltung des Schalters die erste PMU dazu konfiguriert ist, eine Niederspannungskennlinie des BMS zu prüfen.

3. Prüfschaltung nach Anspruch 2, wobei die Prüfschaltung in der ersten Konfiguration des Schalters dazu konfiguriert ist, eine Fähigkeit des BMS zu prüfen, einzelne Anschlussspannungen eines Batteriestapels zu messen.

4. Prüfschaltung nach Anspruch 2 oder Anspruch 3, wobei die Prüfschaltung ferner eine Anzahl "M" von PMUs (313-316; 813-816) umfasst und die Prüfschaltung in der ersten Konfiguration des Schalters dazu konfiguriert ist, den Batteriestapel zu emulieren, der eine Anzahl "M + 2" von Batteriemodulen umfasst, wobei die Anzahl "M" vier oder mehr umfasst.

5. Prüfschaltung nach Anspruch 2 oder Anspruch 3 oder Anspruch 4, wobei die Prüfschaltung ferner eine Anzahl "N" von PMUs (313-316; 813-816) umfasst und die Prüfschaltung in der ersten Konfiguration des Schalters dazu konfiguriert ist, den Batteriestapel zu emulieren, der eine Anzahl "N + 2" von Batteriepacks umfasst, wobei die Anzahl "N+2" ein ganzzahliges Vielfaches von vier umfasst.

6. System, umfassend:
den DUT (360; 860) und
die Prüfschaltung (300; 800) nach Anspruch 1,
wobei der Schalter (346; 846) Konfigurationen aufweist, die aus Folgendem bestehen:
der ersten Konfiguration, bei welcher der Schalter den Low-Sense-Anschluss der ersten PMU mit dem Ausgangsanschluss der zweiten PMU verbindet, und
der zweiten Konfiguration, bei welcher der Schalter den Low-Sense-Anschluss der ersten PMU mit der Gleichtaktspannungsquelle verbindet.

7. System nach Anspruch 6, wobei die Prüfschaltung ferner Folgendes umfasst:
eine dritte PMU (314; 814), umfassend:
eine dritte Elektroquelle (334; 834) und
einen Ausgangsanschluss, um die dritte Elektroquelle mit einem dritten Anschluss des DUT zu verbinden;
eine zweite Gleichtaktspannungsquelle (325; 825), wobei die zweite Gleichtaktspannungsquelle dazu konfiguriert ist, einen größeren Spannungsbereich bei niedrigeren Präzisionsschritten als die erste, zweite und dritte Elektroquelle bereitzustellen; und
einen zweiten Schalter (345; 845);
wobei:
die zweite PMU ferner einen Low-Sense-Anschluss umfasst und
Konfigurationen für den zweiten Schalter aus Folgendem bestehen:
einer ersten Konfiguration, bei welcher der Schalter den Low-Sense-Anschluss der zweiten PMU mit dem Ausgangsanschluss der dritten PMU verbindet, und
einer zweiten Konfiguration, bei welcher der zweite Schalter den Low-Sense-Anschluss der zweiten PMU mit der zweiten Gleichtaktspannungsquelle verbindet.

8. System nach Anspruch 6 oder Anspruch 7, wobei:
die erste Elektroquelle eine erste isolierte Leistungsversorgung ist, die elektrisch verbunden ist, um der ersten PMU eine erste Spannung zuzuführen;
die zweite Elektroquelle eine zweite isolierte Leistungsversorgung ist, die elektrisch verbunden ist, um der zweiten PMU eine zweite Spannung zuzuführen; und
die erste und die zweite Spannung eine höhere Präzision als die Gleichtaktspannungsquelle aufweisen.

9. System nach Anspruch 8, wobei:
die erste isolierte Leistungsversorgung einen Spannungseingangsanschluss, einen Spannungsausgangsanschluss, der mit der ersten PMU verbunden ist, und eine erste Barriere zur galvanischen Trennung, die den Spannungseingangsanschluss von dem Spannungsausgangsanschluss trennt, umfasst;
die zweite isolierte Leistungsversorgung einen Spannungseingangsanschluss, einen Spannungsausgangsanschluss, der mit der zweiten PMU verbunden ist, und eine zweite Barriere zur galvanischen Trennung, die den Spannungseingangsanschluss der zweiten isolierten Leistungsversorgung von dem Spannungsausgangsanschluss der zweiten isolierten Leistungsversorgung trennt, umfasst; und
der Spannungseingangsanschluss der ersten isolierten Leistungsversorgung und der Spannungseingangsanschluss der zweiten isolierten Leistungsversorgung mit einer gemeinsamen Eingangsleistungsversorgung (350; 850) verbunden sind.

10. System nach Anspruch 6 oder einem der Ansprüche 7 bis 9, wobei die erste Elektroquelle mindestens eines der Folgenden umfasst:
eine erste Präzisionsspannungsquelle, um den ersten Anschluss des DUT in einem Kraft-Spannungs-Modus, FV-Modus, anzutreiben; oder
eine erste Präzisionsstromquelle, um den ersten Anschluss des DUT in einem Kraft-Strom-Modus, FI-Modus, anzutreiben.

11. Verfahren zum Verwenden einer Prüfschaltung (300; 800), wobei das Verfahren Folgendes umfasst:
Verbinden eines Ausgangsanschlusses einer ersten parametrischen Messeinheit, PMU, (300; 800) der Prüfschaltung mit einem ersten Anschluss eines Prüflings, DUT, (360; 860);
Verbinden eines Ausgangsanschlusses einer zweiten PMU (315; 815) der Prüfschaltung mit einem zweiten Anschluss des DUT; und
Konfigurieren eines Schalters (346; 846) der Prüfschaltung auf eine der folgenden Konfigurationen:
eine erste Konfiguration, bei welcher der Schalter einen Low-Sense-Anschluss der ersten PMU mit dem Ausgangsanschluss der zweiten PMU verbindet, und
eine zweite Konfiguration, bei welcher der Schalter den Low-Sense-Anschluss der ersten PMU mit Masse verbindet, und
eine dritte Konfiguration, bei welcher der Schalter den Low-Sense-Anschluss der ersten PMU mit einer Gleichtaktspannungsquelle (326; 826) der Prüfschaltung verbindet;
wobei die Gleichtaktspannungsquelle dazu konfiguriert ist, einen größeren Spannungsbereich bei niedrigeren Präzisionsschritten als Elektroquellen der ersten bzw. der zweiten PMU bereitzustellen.

12. Verfahren nach Anspruch 11, wobei:
der DUT ein Batteriemanagementsystem, BMS, umfasst;
in der ersten Konfiguration des Schalters die erste PMU und die zweite PMU in Reihe geschaltet sind, um einen von dem BMS zu verwaltenden Batteriestapel zu emulieren;
in der zweiten Konfiguration des Schalters die erste PMU dazu konfiguriert ist, eine Niederspannungskennlinie des BMS zu prüfen; und
in der dritten Konfiguration des Schalters die erste PMU dazu konfiguriert ist, eine Hochspannungskennlinie des BMS zu prüfen.

13. Verfahren nach Anspruch 12, wobei die Prüfschaltung in der ersten Konfiguration des Schalters dazu konfiguriert ist, eine Fähigkeit des BMS zu prüfen, einzelne Anschlussspannungen eines Batteriestapels zu messen.

14. Verfahren nach Anspruch 11 oder Anspruch 12 oder Anspruch 13, wobei die Elektroquelle der ersten PMU einen oder mehrere Digital-Analog-Umsetzer, DAU, und einen Verstärker umfasst, um Anschlüsse des DUT in einem Kraft-Spannungs-Modus, FV-Modus, einem Kraft-Strom-Modus, FI-Modus, oder einer Kombination davon anzutreiben.

15. Verfahren nach Anspruch 11 oder einem der Ansprüche 11 bis 14, wobei die Prüfschaltung ferner Folgendes umfasst:
eine erste isolierte Leistungsversorgung (336; 836), die elektrisch verbunden ist, um der ersten PMU eine erste Spannung zuzuführen; und
eine zweite isolierte Leistungsversorgung (335; 835), die elektrisch verbunden ist, um der zweiten PMU eine zweite Spannung zuzuführen;
wobei die erste und die zweite Spannung eine höhere Präzision als die Gleichtaktspannungsquelle aufweisen.

## Revendications

1. circuit de test (300 ; 800) comprenant :
une première unité de mesure paramétrique, PMU, (316 ; 816) comprenant :
une première source électrique (336 ; 836),
une borne de sortie pour relier la première source électrique à une première borne d'un dispositif sous test, DUT, (360 ; 860), et
une borne de détection basse ;
une deuxième PMU (315 ; 815) comprenant :
une deuxième source électrique (335 ; 835), et
une borne de sortie pour relier la deuxième source électrique à une deuxième borne du DUT ;
une source de tension en mode commun (326 ; 826), la source de tension en mode commun étant configurée pour fournir une plage de tensions plus large à des pas de précision plus faibles que les première et deuxième sources électriques ; et
un commutateur (346 ; 846) avec des configurations comprenant :
une première configuration dans laquelle le commutateur relie la borne de détection basse de la première PMU à la borne de sortie de la deuxième PMU, et
une deuxième configuration dans laquelle le commutateur relie la borne de détection basse de la première PMU à la source de tension en mode commun.

2. circuit de test selon la revendication 1, dans lequel :
le DUT comprend un système de gestion de batterie, BMS ;
les configurations pour le commutateur comprennent en outre une troisième configuration dans laquelle le commutateur relie la borne de détection basse de la première PMU à la masse ;
dans la première configuration du commutateur, la première PMU et la deuxième PMU sont reliées en série pour émuler un empilement de batteries devant être géré par le BMS ;
dans la deuxième configuration du commutateur, la première PMU est configurée pour réaliser le test d'une caractéristique de haute tension du BMS ; et
dans la troisième configuration du commutateur, la première PMU est configurée pour réaliser le test d'une caractéristique de basse tension du BMS.

3. Circuit de test selon la revendication 2, dans lequel dans la première configuration du commutateur, le circuit de test est configuré pour réaliser le test d'une capacité du BMS à mesurer des tensions de bornes individuelles d'un empilement de batteries.

4. Circuit de test selon la revendication 2 ou la revendication 3, dans lequel le circuit de test comprises en outre un nombre « M » de PMU (313-316 ; 813-816) et, dans la première configuration du commutateur, le circuit de test est configuré pour émuler l'empilement de batteries comprenant un nombre « M + 2 » de modules de batterie, le nombre « M » comprenant quatre modules ou plus.

5. Circuit de test selon la revendication 2, ou la revendication 3 ou la revendication 4, dans lequel le circuit de test comprend en outre un nombre « N » de PMU (313-316 ; 813-816) et, dans la première configuration du commutateur, le circuit de test est configuré pour émuler l'empilement de batteries comprenant un nombre « N + 2 » de blocs-batteries, le nombre « N+2 » comprenant un multiple entier de quatre.

6. Système comprenant :
le DUT (360 ; 860), et
le circuit de test (300 ; 800) selon la revendication 1,
dans lequel le commutateur (346 ; 846) a des configurations consistant en :
la première configuration dans laquelle le commutateur relie la borne de détection basse de la première PMU à la borne de sortie de la deuxième PMU, et
la deuxième configuration dans laquelle le commutateur relie la borne de détection basse de la première PMU à la source de tension en mode commun.

7. Système selon la revendication 6, dans lequel le circuit de test comprend en outre :
une troisième PMU (314 ; 814) comprenant :
une troisième source électrique (334 ; 834), et
une borne de sortie pour relier la troisième source électrique à une troisième borne du DUT ;
une deuxième source de tension en mode commun (325 ; 825), la deuxième source de tension en mode commun étant configurée pour fournir une plage de tensions plus large à des pas de précision plus faibles que les première, deuxième et troisième sources électriques ; et
un deuxième commutateur (345 ; 845) ;
dans lequel :
la deuxième PMU comprend en outre une borne de détection basse, et
les configurations pour le deuxième commutateur consistent en :
une première configuration dans laquelle le deuxième commutateur relie la borne de détection basse de la deuxième PMU à la borne de sortie de la troisième PMU, et
une deuxième configuration dans laquelle le deuxième commutateur relie la borne de détection basse de la deuxième PMU à la deuxième source de tension en mode commun.

8. Système selon la revendication 6 ou la revendication 7, dans lequel :
la première source électrique est une première alimentation électrique isolée reliée électriquement pour fournir une première tension à la première PMU ;
la deuxième source électrique est une deuxième alimentation électrique isolée reliée électriquement pour fournir une deuxième tension à la deuxième PMU ; et
les première et deuxième tensions ont une précision plus élevée que la source de tension en mode commun.

9. Système selon la revendication 8, dans lequel :
la première alimentation électrique isolée comprend une borne d'entrée de tension, une borne de sortie de tension reliée à la première PMU, et une première barrière d'isolation galvanique séparant la borne d'entrée de tension de la borne de sortie de tension ;
la deuxième alimentation électrique isolée comprend une borne d'entrée de tension, une borne de sortie de tension reliée à la deuxième PMU, et une deuxième barrière d'isolation galvanique séparant la borne d'entrée de tension de la deuxième alimentation électrique isolée de la borne de sortie de tension de la deuxième alimentation électrique isolée ; et
la borne d'entrée de tension de la première alimentation électrique isolée et la borne d'entrée de tension de la deuxième alimentation électrique isolée sont reliées à une alimentation électrique d'entrée commune (350 ; 850).

10. Système selon la revendication 6, ou l'une quelconque des revendications 7 à 9, dans lequel la première source électrique comprend au moins une parmi :
une première source de tension de précision pour piloter la première borne du DUT dans un mode de tension forcée, FV ; ou
une première source de courant de précision pour piloter la première borne du DUT dans un mode de courant forcé, FI.

11. Procédé d'utilisation d'un circuit de test (300 ; 800), le procédé comprenant :
la liaison d'une borne de sortie d'une première unité de mesure paramétrique, PMU, (300 ; 800) du circuit de test à une première borne d'un dispositif sous test, DUT, (360 ; 860) ;
la liaison d'une borne de sortie d'une deuxième PMU (315 ; 815) du circuit de test à une deuxième borne du DUT ; et
la configuration d'un commutateur (346 ; 846) du circuit de test dans l'une des configurations suivantes :
une première configuration dans laquelle le commutateur relie une borne de détection basse de la première PMU à la borne de sortie de la deuxième PMU,
une deuxième configuration dans laquelle le commutateur relie la borne de détection basse de la première PMU à la masse, et
une troisième configuration dans laquelle le commutateur relie la borne de détection basse de la première PMU à une source de tension en mode commun (326 ; 826) du circuit de test ;
dans lequel la source de tension en mode commun est configurée pour fournir une plage de tensions plus large à des pas de précision plus faibles que des sources électriques des première et deuxième PMU respectivement.

12. Procédé selon la revendication 11, dans lequel :
le DUT comprend un système de gestion de batterie, BMS ;
dans la première configuration du commutateur, la première PMU et la deuxième PMU sont reliées en série pour émuler un empilement de batteries devant être géré par le BMS ;
dans la deuxième configuration du commutateur, la première PMU est configurée pour réaliser le test d'une caractéristique de basse tension du BMS ; et
dans la troisième configuration du commutateur, la première PMU est configurée pour réaliser le test d'une caractéristique de haute tension du BMS.

13. Procédé selon la revendication 12, dans lequel dans la première configuration du commutateur, le circuit de test est configuré pour réaliser le test d'une capacité du BMS à mesurer des tensions de bornes individuelles d'un empilement de batteries.

14. Procédé selon la revendication 11, ou la revendication 12 ou la revendication 13, dans lequel la source électrique de la première PMU comprend un ou plusieurs convertisseurs numérique-analogique, DAC, et un amplificateur pour piloter des bornes du DUT dans un mode de tension forcée, FV, un mode de courant forcé, FI, ou une combinaison de ceux-ci.

15. Procédé selon la revendication 11, ou l'une quelconque des revendications 11 à 14, dans lequel le circuit de test comprend en outre :
une première alimentation électrique isolée (336 ; 836) reliée électriquement pour fournir une première tension à la première PMU ; et
une deuxième alimentation électrique isolée (335 ; 835) reliée électriquement pour fournir une deuxième tension à la deuxième PMU ;
dans lequel les première et deuxième tensions ont une précision plus élevée que la source de tension en mode commun.
